# EUROPEAN PATENT APPLICATION

(11) **EP 4 693 387 A1**
(43) Date of publication of application: **11.02.2026**
(21) Application number: 25190892.7
(22) Date of filing: 22.07.2025
(51) Int. Cl.: H01L 21/768, H01L 21/268, H01L 23/48, H01L 23/522, H01L 23/528, H10D 84/80, H10D 84/85

(54) **SEMICONDUCTOR CIRCUIT WITH BACKSIDE PARTIAL SILICON VIAS USED FOR CONNECTIONS AND DECOUPLING CAPACITORS**

(30) Priority: 08.08.2024 IN 202441060057
(71) Applicant: NXP USA, Inc., Austin, TX 78735 (US)
(72) Inventor: Reber, Douglas Michael, 5656AG Eindhoven (NL); Bhooshan, Rishi, 5656AG Eindhoven (NL)
(74) Representative: Colaiuda, Antonella

(57) **Abstract**

A backside power and ground distribution network is formed on a wafer substrate layer by selectively etching backside PSV openings through a backside surface of the wafer substrate layer, forming n-type and p-type conductive regions in the wafer substrate layer at the bottoms of first and second backside PSV openings in position for electrical contact with an n-well and p-well regions, and then forming first and second backside PSV conductors in the first and second backside PSV openings to be directly electrically connected over the n-type and p-type conductive regions to the n-well and p-well regions in the wafer substrate layer.

## Description

### BACKGROUND OF THE INVENTION

### Field of the Invention

The present disclosure is directed in general to the field of semiconductor devices. In one aspect, the present disclosure relates to power and ground connector structures formed on and through semiconductor devices.

### Description of the Related Art

Conventionally, integrated circuits use conductive interconnect layers or levels formed on the wafer frontside to provide connect signal and power delivery routing to integrated circuits, but as semiconductor fabrication processes advance toward future nodes with shrinking interconnect stacks, there are increasingly resistance, capacitance, and power consumption issues which arise with using the conductive interconnects on the wafer frontside for both power and signal routing. When the power demand becomes too great, existing solutions have sought to enhance the conductivity of the conductive power supply interconnects, such as by adding more metal levels, making the Alucap (AP) final metallization thicker, or switching to copper pillar arrangements which allow power to be more directly delivered throughout the die, as opposed to wirebonding which is typically only from the chip periphery. In recent years, on-chip power delivery has been improved by decoupling the signal and power delivery routing to the integrated circuits can be decoupled by moving the power wiring to the wafer backside while signal routing is kept in the traditional wafer frontside. However, there are challenges with introducing power signal routing on the wafer backside, including potential interference with backside circuit elements (e.g., decoupling capacitors), processing challenges with creating through silicon via (TSV) interconnects structures in a semiconductor substrate material, process compatibility with wafer front-end-of-line (FEOL) and back-end-of-line (BEOL) wafer fabrication or alternatively for silicon-based package solutions. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1-9 illustrate cross-sectional views at different stages of manufacture of a semiconductor structure having separate backside ground and power delivery conductors formed with partial silicon vias in accordance with selected first embodiments of the present disclosure.
Figure 10 illustrates a cross-sectional view of a semiconductor structure having a backside decoupling capacitor integrated with backside ground and power delivery conductors formed with partial silicon vias in accordance with selected second embodiments of the present disclosure.
Figures 11-16 illustrate cross-sectional views at different stages of manufacture of a semiconductor structure having separate backside ground and power delivery conductors formed with partial silicon vias in accordance with selected third embodiments of the present disclosure.
Figure 17 illustrates a simplified process flow fabricating separate backside ground and power delivery conductors formed with partial semiconductor vias in accordance with selected embodiments of the present disclosure.

### DETAILED DESCRIPTION

An integrated circuit fabrication process and resulting integrated circuit are described for fabricating separate ground and power distribution conductors with backside conductive partial silicon vias (PSV) structures to maximize the power and ground distribution and direct connection buried well regions. Depending on the type of material used to form the wafer semiconductor substrate, the term "PSV" may refer to a "partial silicon via" (when the wafer semiconductor substrate is formed with silicon), but may also refer to a "partial semiconductor via" or a "partial substrate via" (when the wafer semiconductor substrate is formed with a semiconductor material that includes, but is not limited to silicon). In selected embodiments, the backside ground and power distribution conductors are integrated with backside decoupling capacitors plates to maximize the power and ground distribution in a die and decoupling capacitor area while providing a highly effective Electromagnetic Interference (EMI) shield. In selected embodiments, the backside power and ground distribution conductors are fabricated by forming conductive implant regions at the bottom of backside PSV openings prior to performing the FEOL wafer processing steps, and then filling the PSV openings with one or more conductive layers to form the backside power and ground distribution conductors after performing the FEOL wafer processing steps. In other selected embodiments, the backside power and ground distribution conductors are fabricated after substantial completion of the FEOL and BEOL wafer processing steps by forming backside PSV openings conductive after fabricating top-side integrated circuit elements and then annealing implant regions at the bottom of backside PSV openings with a femtosecond laser anneal drive step prior to filling the PSV openings with one or more conductive layers form the backside power and ground distribution conductors.

In this disclosure, an improved integrated circuit design, structure, and method of manufacture are described for forming backside power and ground distribution conductors with conductive partial PSV structures that may be integrated with a backside decoupling capacitor as part of, or after, the back-end-of-line process to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be nonlinear, such as when the described etch processes are applied at different rates to different materials, or when the described deposition or growth processes generate layers based on the underlaying materials.

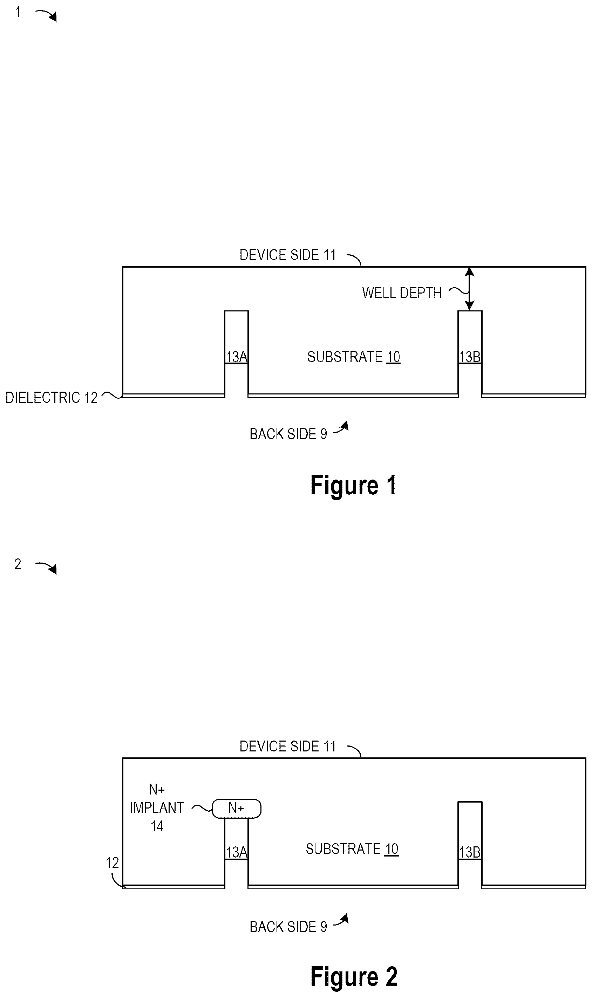

Various illustrative embodiments of the present invention will now be described in detail with reference to Figures 1-17. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

Turning now to Figure 1, there is illustrated in cross-sectional form a portion of a semiconductor structure 1 in which a semiconductor substrate 10 has a backside surface 9 and a device side (or frontside) surface 11 on which IC devices will subsequently be formed. As will be appreciated, the device side surface 11 is the surface on the semiconductor substrate or wafer where IC devices are formed, and the backside surface 9 is the opposite surface on the semiconductor substrate or wafer. The disclosed semiconductor structure 10 may be implemented as a bulk silicon substrate, monocrystalline silicon (doped or undoped), or any semiconductor material including, for example, Si, SiC, SiGe, SiGeC, Ge, GaAs, InAs, InP as well as other Group III-V compound semiconductors or any combination thereof, and may be formed as the bulk handling wafer. In selected embodiments, the depicted semiconductor substrate 10 may have a specified thickness (e.g., 30 um) that is achieved by applying a wafer back grind process. On the backside surface 9 of the semiconductor substrate 10, there is formed one or more patterned dielectric layers 12 and partial silicon via openings 13A/B. As will be understood by those skilled in the art, the patterned dielectric layer 12 is used as part of an etch mask with an anisotropic etch processes to form the partial silicon via openings 13A/B which extend through the backside surface 9 to the approximate depth of the eventual front-side wells. While any suitable anisotropic etch process(es) may be used, the etch processing can start by coating the backside surface 9 with a dielectric layer, and then forming a patterned photoresist mask (not shown) with openings exposing the intended etch regions, and then performing a reactive-ion etching (RIE) step having suitable etch chemistry properties to remove the exposed portions of the underlying dielectric layer 12 and semiconductor substrate 10 to a predetermined well depth. For example, a controlled photo etch process, such as a timed anisotropic dry etch, may be used to remove a portion of the exposed portions of the underlying layers 10, 12 to a predetermined depth which reaches the n-well and p-well regions which are subsequently formed in the semiconductor substrate 10. While the sidewalls of the PSV etch openings 13A/B are substantially vertical, it will be appreciated that minor deviations in the sidewall profile may occur due to etch processing variations.

Figure 2 illustrates processing of the semiconductor structure 2 subsequent to Figure 1 after selectively forming a first conductive implant region 14 at the bottom of selected backside PSV openings 13A in accordance with selected embodiments of the present disclosure. In selected embodiments, the first conductive implant region 14 is formed as an N+ implant by selectively implanting, through the backside surface 9, a suitable n-type dopant (e.g., Phosphorus, antimony, and Arsenic) with a suitable ion implantation energy and dopant concentration. As a preliminary step in the selective implantation process, a patterned implant mask (not shown) may be formed on the backside surface 9 of the substrate 10 by depositing or coating the semiconductor structure backside with a photoresist layer that is subsequently developed and exposed to transfer a pattern from a mask to the semiconductor structure so that the patterned implant mask protects backside surface 9 except for defined openings to expose the intended N+ implant region 14. With the patterned implant mask in place, an n-type ion implantation process is applied to form the N+ implant region 14 at the bottom of the backside PSV openings 13A that is exposed by the patterned implant mask. As disclosed, the implantation power and dosage parameters of the n-type ion implantation process are controlled to implant n-type dopants at the bottom of the backside PSV openings 13A which exposes the subsequently formed n-well region in the semiconductor substrate 10. For example, the n-type implantation process may be configured to implant any suitable n-type implant with an ion implantation energy of approximately 1-100 keV (e.g., 10 keV) and dopant concentration in the range of about 5x1014 to5x1015 atoms/cm2 (e.g., 1015 atoms/cm2), thereby forming the N+ implant 14 at a target implant depth at the bottom of the exposed backside PSV opening 13A. As will be appreciated, the n-type implantation process may use any suitable implantation technique, including but not limited to traditional ion implantation and plasma-immersion ion implantation for implanting the N+ implant 14 in the semiconductor substrate 10. While Figure 2 shows the N+ implant 14 being formed at the bottom of the exposed backside PSV opening 13A, it will be appreciated that some implantation will occur also along the sidewalls of the exposed PSV opening 13A. In addition, it will be understood the N+ implant 14 will actually have approximately the same diameter as the exposed backside PSV opening 13A and will become larger with annealing, but the relative width of the N+ implant 14 is exaggerated for purposes of illustrating the present disclosure. Unless accompanied by a high temperature anneal process, the n-type implantation process will create structural disruptions in the monocrystalline structure of the semiconductor layer 10. In selected embodiments, co-implants can be performed. In addition or in the alternative, a n-type solid phase diffusion source may be used to form the N+ regions 14. However formed, the N+ implant 14 is an n-type well connect for making direct electrical connection to a subsequently formed n-well region in the semiconductor substrate 10.

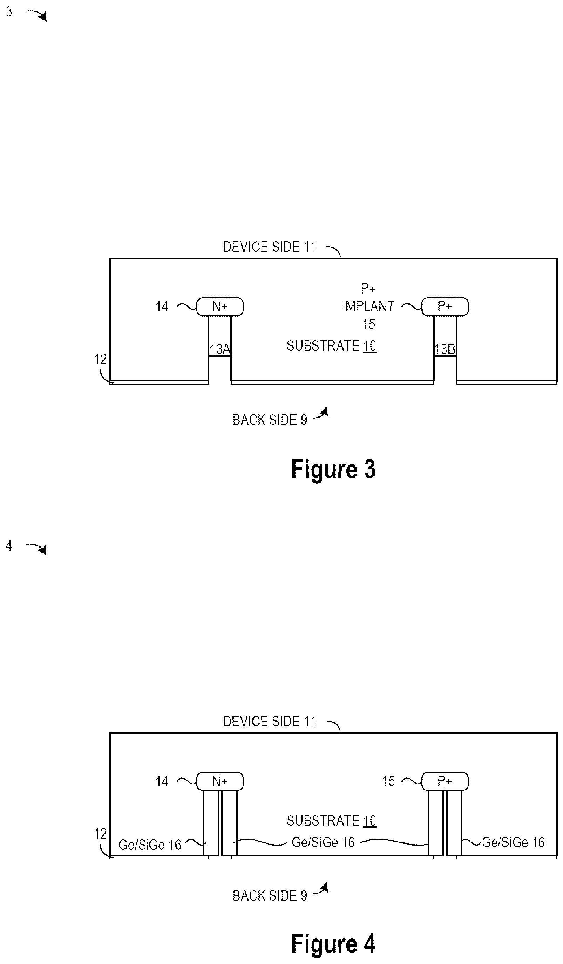

Figure 3 illustrates processing of the semiconductor structure 3 subsequent to Figure 3 after selectively forming a second conductive implant region 15 at the bottom of selected backside PSV openings 13B in accordance with selected embodiments of the present disclosure. In selected embodiments, the second conductive implant region 15 is formed as a P+ implant by selectively implanting, through the backside surface 9, a suitable p-type dopant (e.g., Boron, Arsenic, Phosphorus, Gallium, Aluminum) with a suitable ion implantation energy and dopant concentration. Again, the selective implantation process may include forming a second patterned photoresist implant mask (not shown) which protects backside surface 9 except for defined openings to expose the intended P+ implant region 15, and then performing a p-type ion implantation process to form the P+ implant region 15 at the bottom of the backside PSV opening 13B which exposes the subsequently formed p-well region in the semiconductor substrate 10. For example, the p-type implantation process may be configured to implant any suitable p-type implant with an ion implantation energy of approximately 1-100 keV (e.g., 10 keV) and dopant concentration in the range of about 5x1014 to5x1015 atoms/cm2 (e.g., 1015 atoms/cm2), thereby forming the P+ implant 15 at a target implant depth at the bottom of the exposed backside PSV opening 13B. While Figure 3 shows the P+ implant 15 being formed at the bottom of the exposed backside PSV opening 13B, it will be appreciated that some implantation will occur also along the sidewalls of the exposed PSV opening 13B. In addition, it will be understood the P+ implant 15 will actually have approximately the same diameter as the exposed backside PSV opening 13B and will become larger with annealing, but the relative width of the P+ implant 15 is exaggerated for purposes of illustrating the present disclosure. Unless accompanied by a high temperature anneal process, the p-type implantation process will create structural disruptions in the monocrystalline structure of the semiconductor layer 10. In selected embodiments, co-implants can be performed. In addition or in the alternative, a p-type solid phase diffusion source may be used to form the P+ regions 15. However formed, the P+ implant 15 is a p-type well connect for making direct electrical connection to a subsequently formed p-well region in the semiconductor substrate 10.

Figure 4 illustrates processing of the semiconductor structure 4 subsequent to Figure 3 after selectively forming one or more Germanium-based sidewall layers 16 in the PSV openings 31 in accordance with selected embodiments of the present disclosure. As disclosed herein, the Germanium-based sidewall layers 16 may be formed or grown to at last partially fill the PSV openings using any suitable deposition or growth process, including but not limited to epitaxial growth/deposition/formation, chemical vapor deposition (CVD), plasma-enhanced chemical vapor deposition (PECVD), physical vapor deposition (PVD), molecular beam epitaxy, sputtering, atomic layer deposition (ALD), electron-enhanced ALD (EE-ALD) or the like. In selected embodiments, the Germanium-based sidewall layers 16 may formed by epitaxially growing Ge or Ge:Si to substantially or completely fill the PSV openings 13A/B. As depicted, the epitaxial growth process may consume part of the semiconductor material located at the sidewalls of the PSV openings 13A/B which is converted to form the Germanium-based sidewall layers 16, but this is not necessarily required when forming the Germanium-based sidewall layers 16.

In selected epitaxial growth embodiments, it will be appreciated that the device side surface 11 may be covered with a protective oxide or nitride layer (not shown). The terms "epitaxial growth, "epitaxial deposition" and "epitaxial formation" all refer generally to a semiconductor process for growing a semiconductor material or layer having a (substantially) crystalline structure on a deposition surface of seed semiconductor material or layer having a (substantially) crystalline structure such that the semiconductor material/layer being grown has substantially the same crystalline characteristics as the seed semiconductor material/layer. In an epitaxial deposition process, the chemical reactants provided by the source gases are controlled, and the system parameters are set so that the depositing atoms arrive at the deposition surface of the semiconductor substrate with sufficient energy to move about on the surface such that the depositing atoms orient themselves to the crystal arrangement of the atoms of the deposition surface. Therefore, an epitaxially grown semiconductor material has substantially the same crystalline characteristics as the deposition surface on which the epitaxially grown material is formed (e.g., the semiconductor substrate 10). As will be appreciated by those skilled in the art, several epitaxial techniques have been used for the growth of epilayers of III-V, II-VI compound semiconductors and other materials, including but not limited to Liquid Phase Epitaxy (LPE), Vapor Phase Epitaxy (VPE), Molecular Beam Epitaxy (MBE), Chemical Beam Epitaxy (CBE) and Atomic Layer Epitaxy (ALE), etc. In selected embodiments, any overgrowth of the epitaxial Germanium-based sidewall layers 16 outside of the PSV openings can be selectively removed, polished, or otherwise planarized with the semiconductor substrate 10 as shown. As depicted, the epitaxial growth process may consume part of the semiconductor material located at the sidewalls of the PSV openings 13A/B which is converted to form the Germanium-based sidewall layers 16, but this is not necessarily required when forming the Germanium-based sidewall layers 16.

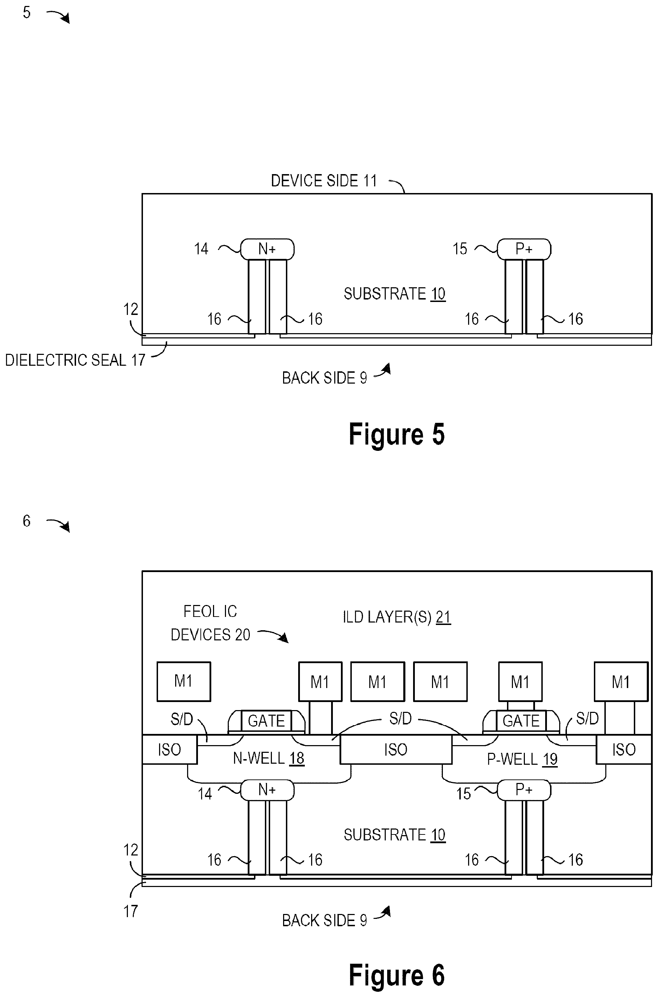

Figure 5 illustrates processing of the semiconductor structure 5 subsequent to Figure 4 after forming a protective dielectric layer 17 on the backside surface 9 of the substrate 10 in accordance with selected embodiments of the present disclosure. In selected embodiments, the protective dielectric layer 17 may be formed by depositing a conformal dielectric layer, such as nitride or silicon oxide, to seal and protect the Germanium-based sidewall layers 16 using any suitable deposition process, including but not limited to CVD, PECVD, PVD, sputtering, ALD, EE-ALD or the like. In selected embodiments, the conformal protective dielectric layer 17 can be selectively etched, polished, or otherwise planarized as shown. As formed, the protective dielectric layer 17 protects the Germanium-based sidewall layers 16 in the PSV openings from subsequent processing steps used to form the IC devices on the device side surface 11.

Figure 6 illustrates processing of the semiconductor structure 6 subsequent to Figure 5 after forming one or more integrated circuit (IC) devices or elements 20 and one or more inter-layer dielectric (ILD) layers 21 and a first metal line conductor layer M1 on the device side surface of the semiconductor substrate 10 in accordance with selected embodiments of the present disclosure. At this point in the fabrication process, the wafer may be flipped and processed to fabricate the IC devices 20 in the semiconductor substrate 10, but for simplicity, the orientation of the semiconductor substrate 10 is not changed in the drawings. As will be appreciated, the FEOL IC devices 20 may include one or more transistors, resistors, capacitors, diodes, or other semiconductor components that are formed on or in the semiconductor substrate 10 that can be formed with any suitable semiconductor material or combinations of materials, such as Gallium arsenide, silicon Germanium, semiconductor-on-insulator (SOI), silicon, monocrystalline silicon, and the like. In upper surfaces of the semiconductor substrate 10, one or more n-well regions 18 and p-well regions 19 are selectively formed using any suitable well formation technique, including but limited to implantation, diffusion, annealing, etc. After forming the n-well regions 18 and p-well regions 19, the FEOL IC devices 20 are formed. For example, the depicted transistors include gates formed over source/drain regions of a channel, where the transistors are separated from one another by isolation regions (ISO) and connected to patterned first metal line conductor layers M1 formed in the ILD layer(s) 21. In addition, the substrate 10 may include one or more Vdd regions, such as an N+ region or buried power rail structures (not shown) which may be formed with any suitable conductive material, such as a metal layer or conductive implants, which is formed to make direct electrical contact with the backside ground and power delivery conductors formed with partial silicon vias, as disclosed herein. As illustrated, the FEOL IC devices 20 are formed on the top or front side of the semiconductor substrate 10, and not on the wafer backside.

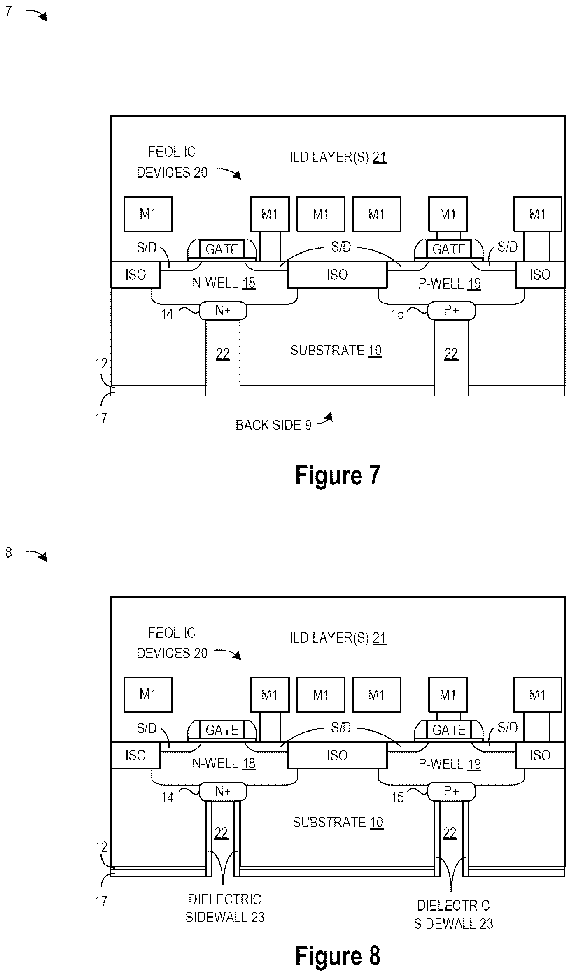

Figure 7 illustrates processing of the semiconductor structure 7 subsequent to Figure 6 after selectively removing the Germanium-based sidewall layers 16 from the PSV openings to expose the N+ implant and P+ implant regions 14, 15 in accordance with selected embodiments of the present disclosure. While any suitable selective etch process may be used, the Germanium-based sidewall layers 16 may be removed by forming an etch mask (not shown) on the backside surface 9 of the substrate with defined openings over the Germanium-based sidewall layers 16, and then applying one or more selective etch processes to remove the exposed portions of the protective dielectric layer 17 and dielectric layer 12. As disclosed herein, the selective etch processes may include a wet etch chemistry that is highly selective to Germanium or SiGe to selectively remove the Germanium-based sidewall layers 16 without removing the semiconductor material (e.g., Si) forming the substrate 10, thereby forming the partial silicon via openings 22 which extend through the backside surface 9 to expose the N+ implant and P+ implant regions 14, 15. In addition or in the alternative, an anisotropic etch may be used to remove the Germanium-based sidewall layers 16 from the PSV openings without etching laterally into the semiconductor substrate 10. While the sidewalls of the PSV etch openings 22 are substantially vertical, it will be appreciated that minor deviations in the sidewall profile may occur due to etch processing variations. In other embodiments, an etch or back-grinding process may be applied to remove the protective dielectric layer 17 and dielectric layer 12 and to thin the semiconductor substrate 10 before selectively removing the Germanium-based sidewall layers 16. In such embodiments, a new back-surface dielectric layer may be formed using a high-pressure deposition process to prevent deposition of the back-surface dielectric layer into the PSV openings 22.

Figure 8 illustrates processing of the semiconductor structure 8 subsequent to Figure 7 after selectively forming dielectric sidewall layers 23 on the sides of the PSV openings 22 in accordance with selected embodiments of the present disclosure. In selected embodiments, the dielectric sidewall layers 23 may be formed by depositing a suitable conformal dielectric layer (e.g., Si3N4, SiO2) to a predetermined thickness using atomic layer deposition (ALD) or any other suitable deposition technique. Subsequently, the deposited conformal dielectric layer may be selectively removed from horizontal surfaces on the backside surface 9 and bottom surfaces of the PSV openings 22 with one or more selective etch processes. For example, a suitable selective etch process is applying an anisotropic or directional etch which removes the deposited dielectric layer from the bottom of the PSV opening(s) 22 while leaving the conformal dielectric layers 23 on the vertical sidewall surfaces of the PSV openings 22. As a result, the N+ implant and P+ implant regions 14, 15 in the PSV openings 22 are exposed. In selected embodiments, the dielectric sidewall layers 23 may be selectively formed on PSV openings 22 which expose the N+ implant regions 14, but not on PSV openings 22 which expose the P+ implant regions 15 in order to allow better connection between the substrate 10 to Vss through the subsequently-formed patterned metal PSV conductors 25.

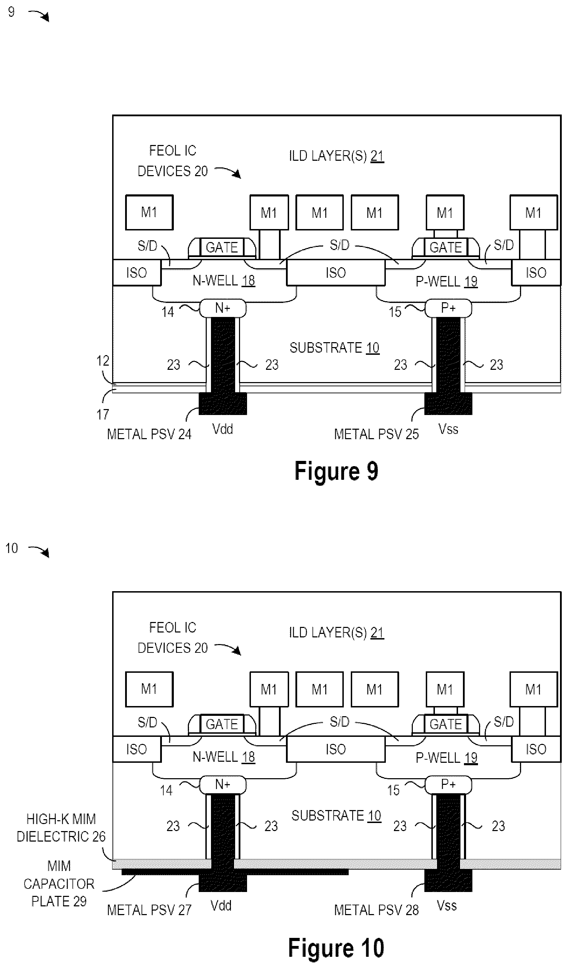

Figure 9 illustrates processing of the semiconductor structure 9 subsequent to Figure 8 after the PSV openings 22 are filled with one or more conductive layers to form metal PSV structures 24, 25 which make direct electrical contact with the n-well region 18 and p-well region 19 through, respectively, the N+ implant region 14 and P+ implant region 15 in accordance with selected embodiments of the present disclosure. In selected embodiments, the metal PSV structures 24, 25 are formed by first depositing, over the backside surface 9 and PSV openings 22, a conductive barrier film or liner layer of any suitable diffusion barrier material which also allows for electrodeposition (e.g., Ti, TiN, Ta, TaN, TiN, TiC, TaC, CuWP, or the like). As part of the conductive barrier film/liner layer, one or more conductive seed layers may be formed with any suitable conductive material, such as copper, a copper alloy, silver, gold, tungsten, Aluminum, or the like. In selected embodiments, the metal PSV structures 24, 25 may be formed by blanket depositing a barrier film in the PSV openings 22, followed by depositing a thin seed layer (e.g., copper or copper alloy, nickel, etc.) over the barrier film, and then filling the PSV openings 22 with metallic material, such as by using electro-plating, electroless plating, or depositing a conductive material (e.g., Cu, Co, Ni, Mn, Mg, Zn, Al, etc.). The electro-plating process may be controlled to provide a bottom-up partial electroplating so that the metallic material is formed only on horizontal surfaces to cover the wafer backside and the bottom of the PSV openings 22 and to make direct electrical contact with the N+ implant and P+ implant regions 14, 15. The deposited conductive layers are then patterned and etched using any suitable selective etch process(es) to form the patterned metal PSV conductor 24 (for connection to the Vdd reference voltage) and the patterned metal PSV conductor 25 (for connection to the Vss reference voltage). In selected embodiments, the patterned metal PSV conductors 24, 25 can be selectively etched, polished, or otherwise planarized as shown. In selected embodiments, the dielectric sidewall layers 23 formed on PSV openings 22 which expose P+ implant regions 15 may be selectively removed before filling the PSV openings 22 with conductive layers in order to allow better connection between the substrate 10 to Vss through the patterned metal PSV conductor 25 the Si substrate.

To provide a further improvement in the fabrication of separate backside ground and power delivery conductors, reference is now made to Figure 10 which depicts a partial cross-sectional view of a semiconductor structure 10 subsequent to Figure 7 wherein a backside decoupling MIM capacitor in integrated with the patterned metal PSV conductors 27, 28 by replacing the protective dielectric layer 17 and dielectric layer 12 with a high-k MIM dielectric layer 26 and a backside MIM capacitor plate 29 in accordance with selected embodiments of the present disclosure. In the depicted semiconductor structure 10, the backside decoupling MIM capacitor is integrated with the patterned metal PSV conductor 27, and includes a high-k MIM dielectric layer 26 sandwiched between a first MIM capacitor plate 29 and a second capacitor plate formed with the semiconductor substrate 10 which serves as the ground electrode. In fabricating the semiconductor structure 10, any suitable process may be used to replace the protective dielectric layer 17 and dielectric layer 12 with a high-k MIM dielectric layer 26. For example, the high-k MIM dielectric layer 26 may be formed by applying a polish and/or etch process to remove the dielectric layers 12, 17 shown in Figure 5, and then depositing a conformal high-k MIM dielectric layer 26 to a predetermined thickness as a protective layer before forming the IC devices 20 and ILD layers 21 on the semiconductor substrate 10. Alternatively, the protective dielectric layer 17 and dielectric layer 12 may be removed by applying a CMP or etch to selectively remove the dielectric layers 12, 17 shown in Figure 8 without removing the dielectric sidewall layers 23 formed in the PSV openings 22, and then subsequently depositing and patterning the high-k MIM dielectric layer 26. Subsequently, the exposed PSV openings are filled with one or more conductive layers, and a patterned etch process is applied to simultaneously form the patterned metal PSV conductor 27 (for connection to the Vdd reference voltage) and the patterned metal PSV conductor 28 (for connection to the Vss reference voltage). In selected embodiments, the high-k MIM dielectric layer 26 may be formed using a high-pressure deposition process to prevent deposition of the back-surface dielectric layer into the PSV openings 22.

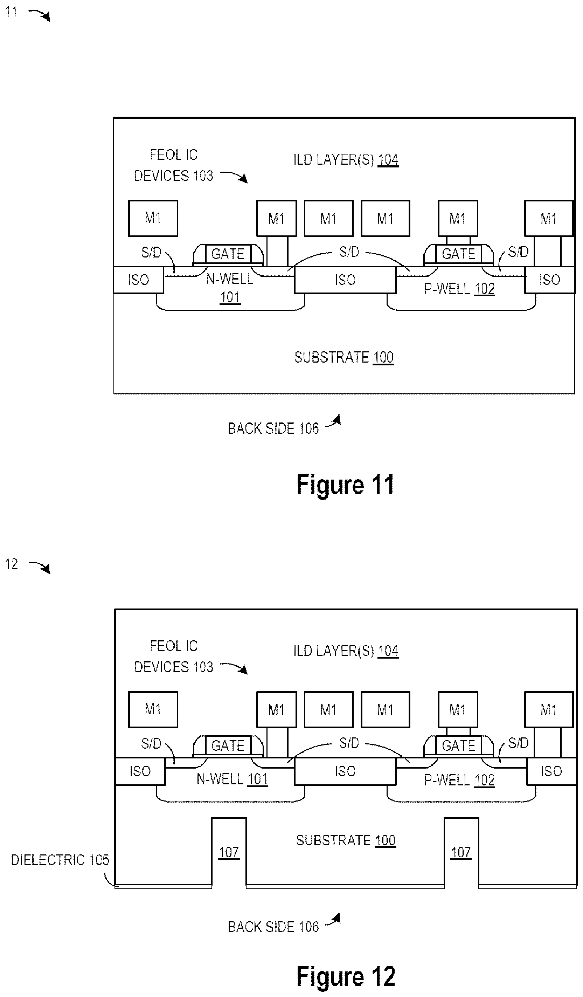

To provide a further improvement in the fabrication of separate backside ground and power delivery conductors, reference is now made to Figure 11 which depicts a partial cross-sectional view of a semiconductor structure 11 having one or more inter-layer dielectric (ILD) layers 104 and a first metal line conductor layer M1 formed over a semiconductor substrate 100 in which one or more n-well regions 101 and/or p-well regions 102 are formed with integrated circuit (IC) devices or elements 103 using front-end-of-line (FEOL) wafer processing steps. As will be appreciated, the FEOL IC devices 103 may include one or more transistors, resistors, capacitors, diodes, or other semiconductor components that are formed on or in a semiconductor substrate that can be formed with any suitable semiconductor material or combinations of materials. For example, the depicted transistors include gates formed over source/drain regions in n-well regions 101 and/or p-well regions 102, where the transistors are separated from one another by isolation regions (ISO) and connected to patterned first metal line conductor layers M1 formed in the ILD layer(s) 104. As illustrated, the FEOL IC devices 103 are formed on the top or front side of the semiconductor structure 11, and not on the wafer backside. As depicted, there are no backside ground and power delivery conductors formed in the semiconductor structure 11.

Figure 12 illustrates processing of the semiconductor structure 12 subsequent to Figure 11 after forming one or more patterned dielectric layers 105 and partial silicon via openings 107 on the backside surface 1006 of the substrate 100. As disclosed herein, the patterned dielectric layer(s) 105 is used as part of an etch mask with an anisotropic etch processes to form the partial silicon via openings 107 which extend through the backside surface 106 to the approximate depth of the n-well regions 101 and p-well regions 102. While any suitable anisotropic etch process(es) may be used, the etch processing can start by coating the backside surface 106 with a dielectric layer, forming a patterned photoresist mask (not shown) with openings exposing the intended etch regions, and then performing a reactive-ion etching (RIE) step having suitable etch chemistry properties to remove the exposed portions of the underlying dielectric layer 105 and semiconductor substrate 100 to a predetermined well depth. While the sidewalls of the PSV etch openings 107 are substantially vertical, it will be appreciated that minor deviations in the sidewall profile may occur due to etch processing variations.

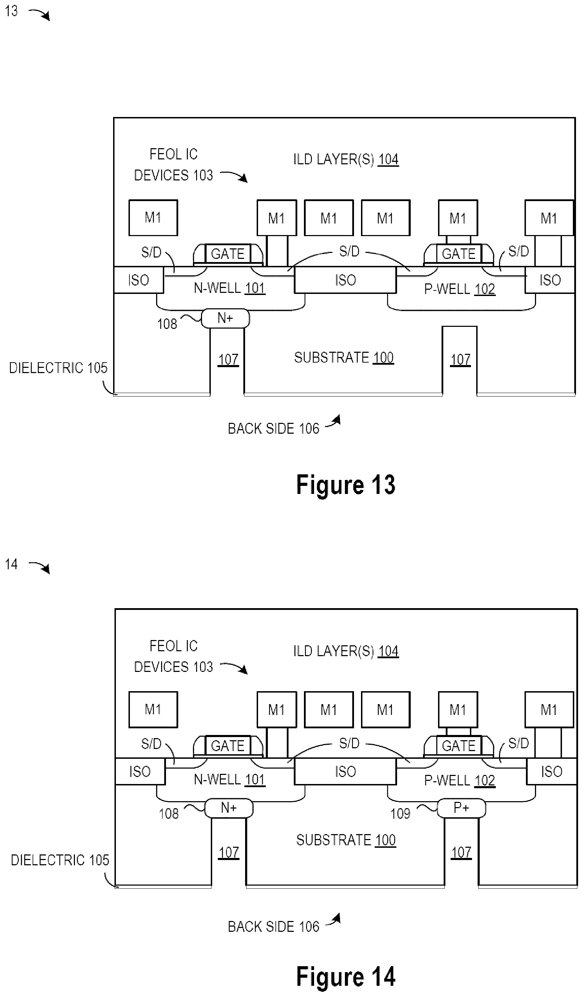

Figure 13 illustrates processing of the semiconductor structure 13 subsequent to Figure 12 after selectively forming a first conductive implant region 108 at the bottom of selected backside PSV openings 107 in accordance with selected embodiments of the present disclosure. Using any suitable selective implantation process, the first conductive implant region 108 is formed as an N+ implant by selectively implanting, through the backside surface 106, a suitable n-type dopant (e.g., Phosphorus, antimony, and Arsenic) with a suitable ion implantation energy and dopant concentration. For example, a first patterned implant mask (not shown) may be formed on the backside surface 106 of the substrate 100 by depositing or coating the semiconductor structure backside with a photoresist layer that is subsequently developed and exposed to transfer a pattern from a mask to the semiconductor structure so that the patterned implant mask protects backside surface 106 except for defined openings to expose the intended N+ implant region 108. With the first patterned implant mask in place, an n-type ion implantation process is applied to form the N+ implant region 108 at the bottom of the backside PSV openings 107 in contact with the n-well region 101 exposed by the patterned implant mask. As disclosed, the implantation power and dosage parameters of the n-type ion implantation process are controlled to implant n-type dopants at the bottom of the backside PSV openings 107 in contact with the n-well region 101 in the semiconductor substrate 100. In selected embodiments, co-implants can be performed. In addition or in the alternative, an n-type solid phase diffusion source may be used to form the N+ regions 108. As formed, the N+ implant 108 is an n-type well connect for making direct electrical connection with the n-well region 101 in the semiconductor substrate 100.

Figure 14 illustrates processing of the semiconductor structure 14 subsequent to Figure 13 after selectively forming a second conductive implant region 109 at the bottom of selected backside PSV openings 107 in accordance with selected embodiments of the present disclosure. Using any suitable selective implantation process, the second conductive implant region 109 is formed as a P+ implant by selectively implanting, through the backside surface 106, a suitable p-type dopant (e.g., Boron, Arsenic, Phosphorus, Gallium, Aluminum) with a suitable ion implantation energy and dopant concentration. For example, a second patterned photoresist implant mask (not shown) may be formed on the backside surface 106 with defined openings to expose the intended P+ implant region 107. With the second patterned implant mask in place, a p-type ion implantation process is applied to form the P+ implant region 109 at the bottom of the backside PSV opening 107 in contact with the p-well region 102 exposed by the patterned implant mask. In selected embodiments, co-implants can be performed. In addition or in the alternative, a p-type solid phase diffusion source may be used to form the P+ regions 109. As formed, the P+ implant 109 is a p-type well connect for making direct electrical connection with the p-well region 102 in the semiconductor substrate 10.

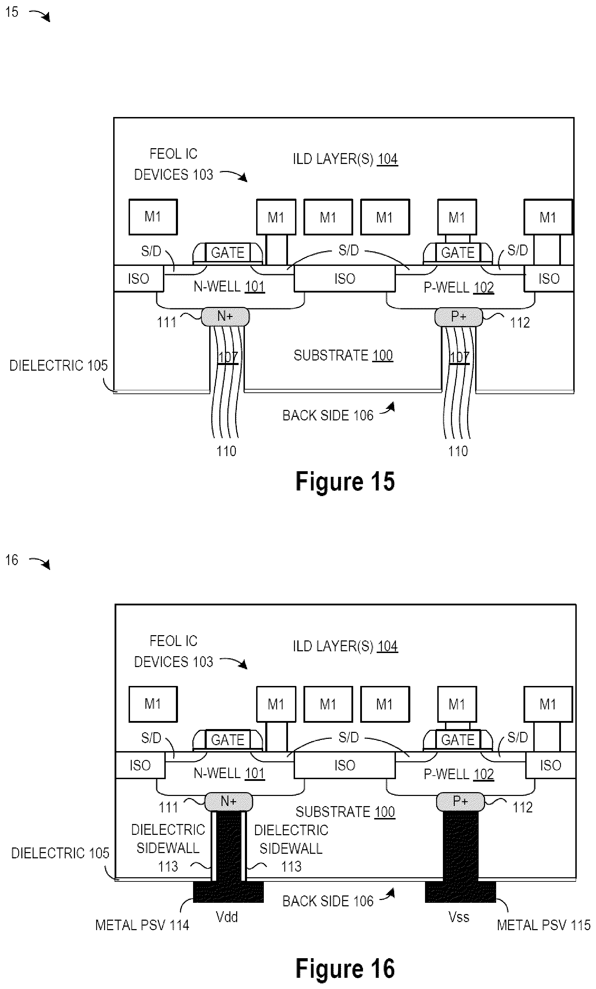

As will be appreciated, the n-type and p-type implantation processes will create structural disruptions in the monocrystalline structure of the semiconductor layer 100. However, any attempt to apply a high temperature anneal process to remove the structural disruptions at this stage of the device fabrication will drive dopants in the FEOL IC devices 103 and n-well/p-well regions 101, 102, thereby adversely impacting the front-side circuits. To address this issue, reference is now made to Figure 15 which illustrates processing of the semiconductor structure 15 subsequent to Figure 14 after applying a localized anneal process 110 to form conductive N+ and P+ regions 111, 112 at the bottom of selected backside PSV openings 107 in accordance with selected embodiments of the present disclosure. In selected embodiments, the localized anneal process 110 may be implemented to avoid impacting the front-side circuits by scanning a femtosecond laser 110 into the PSV openings 107 or using any other suitable localized anneal process. However implemented, the localized anneal process 110 is substantially confined to remove the structural disruptions in the N+ and P+ regions 108, 109 to form the conductive N+ and P+ regions 111, 112, but to otherwise not affect the diffusions in the FEOL IC devices 103 and n-well/p-well regions 101, 102.

Figure 16 illustrates processing of the semiconductor structure 16 subsequent to Figure 15 after selectively forming dielectric sidewall layers 113 on the sides of the Vdd PSV openings 107 and then filling the remaining PSV openings 107 with one or more conductive layers to form metal PSV structures 114, 115 which make direct electrical contact with the n-well region 101 and p-well region 102 through, respectively, the N+ implant region 111 and P+ implant region 112 in accordance with selected embodiments of the present disclosure. As illustrated, the dielectric sidewall layers 113 may be formed by selectively depositing a suitable conformal dielectric layer (e.g., Si3N4, SiO2) in the Vdd PSV opening 107 to a predetermined thickness using any suitable selective deposition technique (e.g., a nitride-masked deposition process), and then selectively etching the conformal dielectric layer (e.g., with an anisotropic or directional etch) which removes the conformal dielectric layer from the bottom of the Vdd PSV opening 107 while leaving the conformal dielectric layers 113 on the vertical sidewall surfaces of the Vdd PSV opening 107. As a result, the N+ implant and P+ implant regions 111, 112 in the PSV openings 107 are exposed. Subsequently, the metal PSV structures 114, 115 may be formed by depositing, over the backside surface 106 and PSV openings 107, a conductive barrier film or liner layer, followed by depositing one or more conductive seed layers over the barrier film, and then filling the PSV openings 107 with metallic material, such as by using electro-plating, electroless plating, or depositing a conductive material. The deposited conductive layers are then patterned and etched using any suitable selective etch process(es) to form the patterned metal PSV conductor 114 (for connection to the Vdd reference voltage) and the patterned metal PSV conductor 115 (for connection to the Vss reference voltage). In selected embodiments, the patterned metal PSV conductors 114, 115 can be selectively etched, polished, or otherwise planarized as shown.

One of the advantages of the fabrication process shown in Figures 13-16 is that the semiconductor substrate wafer can be etched or back-grinded to a reduced thickness (e.g., ~30um) that can reduce the process time required for etching the PSV openings 107. And as an alternative to implanting the N+ implant region 111 and P+ implant region 112, a high dopant source material can be selectively deposited in the PSV openings 107 prior to applying the localized anneal process 110 to drive the deposited dopant sources.

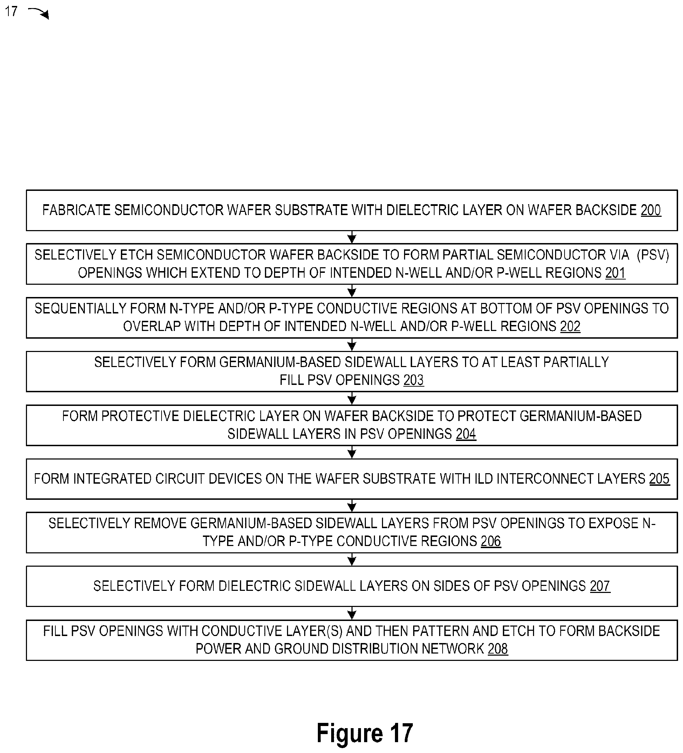

Turning now to Figure 17, there is illustrated a simplified process flow 17 for fabricating separate backside ground and power delivery conductors formed with partial semiconductor vias (PSV) in accordance with selected embodiments of the present disclosure. Though selected embodiments of the backside ground and power delivery conductor fabrication methodology are described with reference to an example fabrication process that can be integrated with a FEOL or BEOL process, it will be appreciated by persons skilled in the art that the sequence of illustrated steps may be used in any suitable stage of the device fabrication process, and may be modified, reduced or augmented in keeping with the disclosure of the present invention. Thus, it will be appreciated that the methodology of the present disclosure may be thought of as performing the identified sequence of steps in the order depicted in Figure 17, though the steps may also be performed in parallel, in a different order, or as independent operations that are combined.

The disclosed fabrication methodology begins with one or more processing steps 200 which are used to fabricate a wafer with a semiconductor substrate having one or more dielectric layers formed on the backside of the semiconductor substrate. As disclosed herein, the semiconductor wafer substrate may be implemented as a bulk silicon substrate, monocrystalline silicon (doped or undoped), or any semiconductor material including, for example, Si, SiC, SiGe, SiGeC, Ge, GaAs, InAs, InP as well as other Group III-V compound semiconductors or any combination thereof, and may be formed as the bulk handling wafer. In addition, the dielectric layer may be formed by depositing a layer of silicon oxide or silicon nitride to a predetermined thickness.

At step 201, partial semiconductor via (PSV) openings are selectively etched through the dielectric layer and into the wafer backside to extend to the depth of the intended n-well and p-well regions and/or to contact buried Vdd and/or Vss regions or power rails formed in the semiconductor substrate. As disclosed herein, the PSV openings do not extend through the entirety of the wafer substrate, but are etched only partially through the wafer substrate to a predetermined etch depth. As disclosed herein, the PSV openings can be formed simultaneously or sequentially by using any suitable masked etch process, such as by forming a patterned photoresist layer as an etch mask and then applying one or more anisotropic etch processes to etch partially through backside of the wafer substrate.

At step 202, n-type and/or p-type conductive regions are selectively formed at the bottom of the PSV openings to overlap with the intended location of the subsequently formed intended n-well and p-well regions. In an example embodiment, the n-type and/or p-type conductive regions may be formed by selectively depositing and annealing a high dopant source material in the PSV openings holes. In addition or in the alternative, the PSV openings can be selectively implanted with n-type or p-type implants and then annealed to remove structural implant damage from the wafer substrate. In other embodiments, a localized anneal process, such as a scanning femtosecond laser, may be applied to locally anneal the implanted N+ and P+ regions.

At step 203, Germanium-based sidewall layers are selectively formed to at least partially fill the PSV openings. In selected embodiments, the Germanium-based sidewall layers may be formed in the PSV openings with epitaxial Germanium or silicon Germanium to substantially or completely fill the PSV openings.

At step 204, a protective dielectric layer is formed on the wafer backside to protect the Germanium-based sidewall layers in the PSV openings from subsequent FEOL processing. In selected embodiments, the protective dielectric layer may be formed by depositing a conformal layer of nitride over the wafer backside to seal the Germanium-based sidewall layers in the PSV openings, and then performing a chemical mechanical polish (CMP) step to planarize the protective dielectric layer.

At step 205, one or more processing steps are performed to fabricate integrated circuit elements (e.g., transistors, capacitors, resistors, diodes, etc.) and ILKD interconnect layers on the wafer substrate. In selected embodiments, front-end-of-line (FEOL) processing steps are the IC fabrication steps where the individual components (transistors, capacitors, resistors, etc.) are patterned in the wafer substrate, and generally covers everything up to (but not including) the deposition of metal interconnect layers and ILD layers. In addition, back-end-of-line (BEOL) processing steps are the IC fabrication steps where the metal interconnect and ILD layers are formed.

At step 206, the Germanium-based sidewall layers are selectively removed from the PSV openings to expose the N+ and/or P+ conductive regions. In selected embodiments, the Germanium-based sidewall layers may be removed by forming a patterned etch mask on the wafer backside with defined openings over the Germanium-based sidewall layers, and then applying one or more selective etch processes to remove the exposed portions of the protective dielectric layer and dielectric layer. Subsequently, a selective etch process is applied to remove the Germanium-based sidewall layers, such as by applying a wet etch chemistry that is highly selective to Germanium or SiGe to selectively remove the Germanium-based sidewall layers, thereby forming the PSV openings which extend to expose the N+ and P+ conductive regions. Alternatively, an anisotropic etch may be used to remove the Germanium-based sidewall layers from the PSV openings without etching laterally into the wafer substrate.

At step 207, dielectric sidewall layers are selectively formed on the sidewalls (but not on the bottom) of the PSV openings. In selected embodiments, the dielectric sidewall layers may be formed by depositing a conformal dielectric layer over the wafer backside, followed by application of an anisotropic etch process which selectively removes the conformal dielectric layer from the wafer backside and the bottom (but not the sidewalls) of the PSV openings.

At step 208, the PSV openings are filled with one or more conductive layers, and then patterned and etched to form the backside power and ground distribution network. In selected embodiments, the one or more conductive layers may be formed by sequentially depositing a seed layer and electroplating layer(s) to fill the PSV openings. The conductive layers may be planarized, patterned and etched on the wafer backside to form a first metal PSV plate that is connected to the Vdd reference voltage, and to form a second metal PSV plate that is connected to the Vss reference voltage.

As described hereinabove, the present disclosure provides a mechanism for integrating backside power and ground distribution network conductors with a backside decoupling capacitor by adding conductive partial-silicon via structures formed on the wafer backside that electrically connect buried n-well and p-well regions in the wafer substrate to external reference voltage supplies. In addition to reducing fabrication costs and complexity for making power and ground connections, the disclosed backside power and ground distribution network reduces front-side metallization congestion, resistance, capacitance, and power consumption issues for routing power and ground signals through the substrate backside, while also providing improved EMI shielding from the decoupling capacitor plates and TSVs. In addition, the backside power and ground distribution network conductors do not traverse entirely through the semiconductor substrate and do not protrude to the top active semiconductor substrate surface, thereby reducing the need for designers to incorporate keep-out-zones and stress concerns encountered with through-silicon vias (TSV) which extend through the entirety of the semiconductor substrate. In addition, the integrating of a backside decoupling capacitor with the backside power and ground distribution network conductors enables high capacitance back-side MIM decoupling capacitors.

By now, it should be appreciated that there has been provided a semiconductor wafer with backside power and ground delivery conductors and associated method of fabrication. In the disclosed methodology, a semiconductor wafer substrate layer is provided that has frontside and backside surfaces. The disclosed methodology also includes selectively etching a plurality of backside partial-semiconductor via (PSV) openings through the backside surface of the semiconductor wafer substrate layer. In addition, the disclosed methodology includes forming an n-type conductive region in the semiconductor wafer substrate layer at a bottom of a first backside PSV opening which is positioned for electrical contact with an n-well region in the semiconductor wafer substrate layer, where the n-well region is formed before or after forming the n-type conductive region. The disclosed methodology also includes forming a p-type conductive region in the semiconductor wafer substrate layer at a bottom of a second backside PSV opening which is positioned for electrical contact with a p-well region in the semiconductor wafer substrate layer, where the p-well region is formed before or after forming the p-type conductive region. In selected embodiments, the n-type conductive region is formed by selectively implanting an N+ implant region into the semiconductor wafer substrate layer at the bottom of the first backside PSV opening, and the p-type conductive region is formed by selectively implanting a P+ implant region into the semiconductor wafer substrate layer at the bottom of the second backside PSV opening. In such embodiments, a femtosecond laser may be scanned to apply a localized anneal process to anneal the N+ implant region and the P+ implant region. In addition, the disclosed methodology includes forming, in the first backside PSV opening, a first backside PSV conductor which is directly electrically connected over the n-type conductive region to the n-well region in the semiconductor wafer substrate layer. The disclosed methodology also includes forming, in the second PSV opening, a second backside PSV conductor which is directly electrically connected over the p-type conductive region to the p-well region in the semiconductor wafer substrate layer. In selected embodiments of the disclosed methodology, a plurality of integrated circuit (IC) devices is formed on the frontside surface of the semiconductor wafer substrate layer after forming the n-type and p-type conductive regions and before forming the first and second backside PSV conductors, where the n-well and p-well regions are formed after forming the n-type and p-type conductive regions. In other selected embodiments of the disclosed methodology, the plurality of integrated circuit (IC) devices is formed on the frontside surface of the semiconductor wafer substrate layer before selectively etching the plurality of backside PSV openings, where the n-well and p-well regions are formed before forming the n-type and p-type conductive regions. In selected embodiments, the disclosed method may also include selectively forming one or more dielectric sidewall layers in the first backside PSV opening which leaves exposed the n-type conductive region. In selected embodiments, the disclosed methodology also includes forming a decoupling metal-insulator-metal (MIM) capacitor plate layer on the backside surface of the semiconductor wafer substrate layer as part of forming the first backside PSV conductor. In selected embodiments, the disclosed methodology includes a number of steps that are performed before forming the first and second backside PSV conductors, including forming one or more semiconductor sidewall layers to at least partially fill the first and second backside PSV openings with a first semiconductor material that is different from a second semiconductor material used to form the semiconductor wafer substrate layer; depositing a conformal dielectric layer on the backside surface of the semiconductor wafer substrate layer to protect the semiconductor sidewall layers in the first and second backside PSV openings; and then forming a plurality of integrated circuit (IC) devices on the frontside surface of the semiconductor wafer substrate layer; and then patterning and etching the conformal dielectric layer on the backside surface of the semiconductor wafer substrate layer to expose the semiconductor sidewall layers in the first and second backside PSV openings; and then selectively removing the semiconductor sidewall layers from the first and second backside PSV openings to expose the n-type and p-type conductive regions; and then selectively forming dielectric sidewall layers in the first and second backside PSV openings which leave exposed the n-type and p-type conductive regions. In such embodiments, the formation of the first and second backside PSV conductors may include sequentially depositing, after forming the dielectric sidewall layers in the first and second backside PSV openings, one or more conductive layers to fill the first and second backside PSV openings and to cover the backside surface of the semiconductor wafer substrate layer; and selectively etching the one or more conductive layers on the backside surface of the semiconductor wafer substrate layer to form the first and second backside PSV conductors.

In another form, there is provided a method of forming power distribution conductors on a backside of a silicon substrate layer with an integrated backside decoupling capacitor plate. In the disclosed methodology, first and second partial-silicon via (PSV) openings are selectively formed on a backside surface of a silicon substrate layer to extend only partway through the silicon substrate layer. In addition, a first conductive region of a first conductivity type is selectively formed at a bottom portion of the first PSV opening to be positioned for electrical contact with a first well region in the silicon substrate layer. In selected embodiments, the first conductive region is formed by selectively implanting an N+ implant region into the silicon substrate layer at the bottom of the first PSV opening, and the second conductive region is selectively formed by selectively implanting a P+ implant region into the silicon substrate layer at the bottom of the second PSV opening. In such embodiments, the disclosed method may further include scanning a femtosecond laser to apply a localized anneal process to anneal the N+ implant region and P+ implant region. In addition, a second conductive region of a second, opposite conductivity type is selectively formed at a bottom portion of the second PSV opening to be positioned for electrical contact with a second well region in the silicon substrate layer. In addition, one or more dielectric sidewall layers are selectively formed on sidewall surfaces of the first and second PSV openings which leave exposed the first and second conductive regions. In addition, a first backside power distribution conductor is selectively formed which is directly electrically connected over the first conductive region to the first well region in the silicon substrate layer. In selected embodiments, the first backside power distribution conductor is selectively formed by sequentially depositing one or more conductive layers to fill the first PSV opening and to cover the backside surface of the silicon substrate layer; and selectively etching the one or more conductive layers on the backside surface of the silicon substrate layer to form the first backside power distribution conductor. In addition, a second backside power distribution conductor is selectively formed which is directly electrically connected over the second conductive region to the second well region in the silicon substrate layer. In selected embodiments, the second backside power distribution conductor is selectively formed by sequentially depositing one or more conductive layers to fill the second PSV opening and to cover the backside surface of the silicon substrate layer; and selectively etching the one or more conductive layers on the backside surface of the silicon substrate layer to form the second backside power distribution conductor. In addition, one or more patterned conductive layers are selectively formed on the backside surface of the silicon substrate layer to form an integrated backside decoupling capacitor plate which is directly electrically connected with the first or second backside power distribution conductor. In selected embodiments, the integrated backside decoupling capacitor plate is a first metal-insulator-metal (MIM) capacitor plate and the silicon substrate layer is a second MIM capacitor plate. Selected embodiments of the disclosed method form a plurality of IC devices on a frontside surface of the silicon substrate layer after selectively forming the first and second conductive regions and before forming the first and second backside power distribution conductors. Other selected embodiments of the disclosed method form plurality of IC devices on the frontside surface of the silicon substrate layer before selectively forming the first and second PSV openings. Before selectively forming one or more dielectric sidewall layers, selective embodiments of the disclosed method may form one or more semiconductor sidewall layers to at least partially fill the first and second PSV openings with a first semiconductor material that is different from a silicon substrate layer; and may then seal the backside surface of the silicon substrate layer with a dielectric layer to protect the one or more semiconductor sidewall layers in the first and second PSV openings before forming a plurality of integrated circuit (IC) devices on the frontside surface of the silicon substrate layer. In such embodiments, selective embodiments of the disclosed method may, after forming the plurality of IC devices on the frontside surface of the silicon substrate layer, pattern and etch the dielectric layer to expose the one or more semiconductor sidewall layers in the first and second backside PSV openings; and the selectively remove the or more semiconductor sidewall layers from the first and second PSV openings to expose the first and second conductive regions before selectively forming the one or more dielectric sidewall layers on sidewall surfaces of the first and second PSV openings which leave exposed the first and second conductive regions.

In yet another form, there is provided an integrated circuit and associated method of fabrication. As disclosed, the integrated circuit includes a semiconductor substrate having first and second well regions located below a frontside surface of the semiconductor substrate with a plurality of integrated circuit (IC) devices formed on the frontside surface of the semiconductor substrate. In addition, the integrated circuit includes first and second conductive regions located in the semiconductor substrate and in electrical contact with, respectively, the first and second well regions. The integrated circuit also includes first and second conductive partial-semiconductor via (PSV) structures formed through a backside surface of the semiconductor substrate to extend only partway through the semiconductor substrate to directly, electrically connect, to the first and second well regions through the first and second conductive regions. In selected embodiments, the integrated circuit also includes an integrated backside decoupling capacitor plate which is directly electrically connected with the first or second conductive PSV structures.

Although the described exemplary embodiments disclosed herein are directed to various semiconductor and integrated circuit device structures and methods for making the same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for fabricating backside ground and power delivery conductors, comprising:
providing a semiconductor wafer substrate layer having frontside and backside surfaces;
selectively etching a plurality of backside partial-semiconductor via (PSV) openings through the backside surface of the semiconductor wafer substrate layer;
forming an n-type conductive region in the semiconductor wafer substrate layer at a bottom of a first backside PSV opening which is positioned for electrical contact with an n-well region in the semiconductor wafer substrate layer, where the n-well region is formed before or after forming the n-type conductive region;
forming a p-type conductive region in the semiconductor wafer substrate layer at a bottom of a second backside PSV opening which is positioned for electrical contact with a p-well region in the semiconductor wafer substrate layer, where the p-well region is formed before or after forming the p-type conductive region;
forming, in the first backside PSV opening, a first backside PSV conductor which is directly electrically connected over the n-type conductive region to the n-well region in the semiconductor wafer substrate layer; and
forming, in the second PSV opening, a second backside PSV conductor which is directly electrically connected over the p-type conductive region to the p-well region in the semiconductor wafer substrate layer.

2. The method of claim 1, further comprising forming a plurality of integrated circuit (IC) devices on the frontside surface of the semiconductor wafer substrate layer after forming the n-type and p-type conductive regions and before forming the first and second backside PSV conductors, where the n-well and p-well regions are formed after forming the n-type and p-type conductive regions.

3. The method according to any preceding claim, further comprising forming a plurality of integrated circuit (IC) devices on the frontside surface of the semiconductor wafer substrate layer before selectively etching the plurality of backside PSV openings, where the n-well and p-well regions are formed before forming the n-type and p-type conductive regions.

4. The method according to any preceding claim, further comprising selectively forming one or more dielectric sidewall layers in the first backside PSV opening which leaves exposed the n-type conductive region.

5. The method according to any preceding claim, further comprising forming a decoupling metal-insulator-metal (MIM) capacitor plate layer on the backside surface of the semiconductor wafer substrate layer as part of forming the first backside PSV conductor.

6. The method according to any preceding claim, where forming the n-type conductive region comprises selectively implanting an N+ implant region into the semiconductor wafer substrate layer at the bottom of the first backside PSV opening, and where forming the p-type conductive region comprises selectively implanting a P+ implant region into the semiconductor wafer substrate layer at the bottom of the second backside PSV opening.

7. The method of claim 6, further comprising scanning a femtosecond laser to apply a localized anneal process to anneal the N+ implant region and the P+ implant region.

8. The method according to any preceding claim, further comprising, before forming the first and second backside PSV conductors:
forming one or more semiconductor sidewall layers to at least partially fill the first and second backside PSV openings with a first semiconductor material that is different from a second semiconductor material used to form the semiconductor wafer substrate layer;
depositing a conformal dielectric layer on the backside surface of the semiconductor wafer substrate layer to protect the semiconductor sidewall layers in the first and second backside PSV openings; and then
forming a plurality of integrated circuit (IC) devices on the frontside surface of the semiconductor wafer substrate layer; and then
patterning and etching the conformal dielectric layer on the backside surface of the semiconductor wafer substrate layer to expose the semiconductor sidewall layers in the first and second backside PSV openings; and then
selectively removing the semiconductor sidewall layers from the first and second backside PSV openings to expose the n-type and p-type conductive regions; and then
selectively forming dielectric sidewall layers in the first and second backside PSV openings which leave exposed the n-type and p-type conductive regions.

9. The method of claim 8, where forming the first and second backside PSV conductors comprises:
sequentially depositing, after forming the dielectric sidewall layers in the first and second backside PSV openings, one or more conductive layers to fill the first and second backside PSV openings and to cover the backside surface of the semiconductor wafer substrate layer; and
selectively etching the one or more conductive layers on the backside surface of the semiconductor wafer substrate layer to form the first and second backside PSV conductors.

10. An integrated circuit, comprising:
a semiconductor substrate comprising first and second well regions located below a frontside surface of the semiconductor substrate with a plurality of integrated circuit (IC) devices formed on the frontside surface of the semiconductor substrate;
first and second conductive regions located in the semiconductor substrate and in electrical contact with, respectively, the first and second well regions; and
first and second conductive partial-semiconductor via (PSV) structures formed through a backside surface of the semiconductor substrate to extend only partway through the semiconductor substrate to directly, electrically connect, to the first and second well regions through the first and second conductive regions.

11. The integrated circuit of claim 10, further comprising an integrated backside decoupling capacitor plate which is directly electrically connected with the first or second conductive PSV structures.
